# EUROPEAN PATENT APPLICATION

(11) **EP 2 040 285 A1**
(43) Date of publication of application: **25.03.2009**
(21) Application number: 07291113.4
(22) Date of filing: 19.09.2007
(51) Int. Cl.: H01L 21/18, H01L 21/762, H01L 21/265

(54) **Method for fabricating a mixed orientation substrate**

(71) Applicant: S.O.I. TEC Silicon, 38190 Bernin (FR)
(72) Inventor: Hebras, Xavier, 38100 Grenoble (FR); Lallement, Fabrice, 73100 Aix les Bains (FR); Landru, Didier, 38190 Champ Pres Froges (FR)
(74) Representative: Grünecker, Kinkeldey, Stockmair & Schwanhäusser Anwaltssozietät

(57) **Abstract**

The invention relates to a method for fabricating a mixed orientation substrate comprising the steps of providing a donor substrate with a first crystalline orientation, forming a predetermined splitting area in the donor substrate, providing a handle substrate, in particular of a second crystalline orientation, attaching the donor substrate to the handle substrate and detaching the donor substrate at the predetermined splitting area thereby transferring a layer of the donor substrate onto the handle substrate to form a mixed orientation substrate. In order to cope with stress introduced during ion implantation, a stiffening layer is provided on the donor substrate prior to forming the predetermined splitting area.

## Description

The invention relates to a method for fabricating a mixed orientation substrate comprising the steps of providing a donor substrate with a first crystalline orientation, forming a predetermined splitting area in the donor substrate, providing a handle substrate, in particular of a second crystalline orientation being different from the first crystalline orientation, attaching, in particular by bonding, the donor substrate to the handle substrate and detaching the donor substrate at the predetermined splitting area, thereby transferring a layer of the donor substrate onto the handle substrate to form a mixed orientation substrate. The invention furthermore relates to a mixed orientation substrate fabricated according to this method.

Such a method for fabricating a mixed orientation substrate is known from K. Bourdelle et al., ECS Transactions, 3(4) 409 to 415 (2006) disclosing the use of the Smart Cut^{™} technology to fabricate a direct silicon bonding (DSB) substrate by transferring a thin layer of a silicon (110) wafer onto a silicon (100) wafer. Therein the schematic process flow is described as follows: A silicon (110) wafer is provided and a predetermined splitting area is created in the silicon (110) wafer using ion implantation. The implanted silicon wafer is then bonded to another silicon wafer, with a (100) surface orientation and the layer transfer from the (110) type wafer onto the (100) type wafer is accomplished by a thermal or mechanical treatment. The obtained DSB structure then undergoes post-splitting process steps to smoothen the surface and to anneal the transferred layer.

However, it was observed that during the implantation step the substrate broke along the most fragile crystalline planes and scratches were observed in the transferred layers. This phenomenon was particularly pronounced in the case of silicon (110). Zheng et al., Journal of Applied Physics, Volume 89, No. 5, March 1, 2001, page 2972 to page 2977 confirmed that the stress inside the donor substrate created by the ion implantation is higher for silicon (110) than for silicon (100).

It is therefore the object of the present invention to provide a method for fabricating a mixed orientation substrate with which independently of the crystalline orientation of the substrates used in the fabrication process, a layer from the donor substrate can be transferred onto a handle substrate without the unwanted effect of breakage along crystalline planes occurring.

This object is achieved with the method according to claim 1. By subjecting the donor substrate to a stress preventing measure, the stress occurring in the donor substrate can be reduced such that the problem of substrate breaking can be reduced.

Advantageously, according to a first inventive aspect, Step b) can comprise providing a stiffening layer (5) over the surface of the donor substrate. By providing a stiffening layer, the crystalline structure of the substrate is strengthened such that cleavage no longer occurs during implantation. Thus, substrates which are normally too fragile, can nevertheless be used in a Smart Cut^{™}type process as donor substrates.

Preferably, the stiffening layer can have a thickness of at least 50 nm, in particular 50 nm to 200 nm, even more in particular about 150 nm. The layer needs a certain minimum thickness to provide the desired effect. By keeping the thickness nevertheless below a certain value, the introduction of the additional process step does not lead to an unnecessary prolongation of the overall process.

According to an advantageous embodiment, the stiffening layer can be at least partially removed prior to Step e). It is the role of the stiffening layer to prevent the cleavage during the implanting process, thus, for the mixed orientation substrate itself, the layer is no longer necessary.

Advantageously, after thinning the stiffening layer, the stiffening layer can have a thickness of at most 50 nm, in particular 25 nm. Thus, in case the mixed orientation substrate shall not only comprise the transferred layer from the donor substrate and the handle substrate, but that an additional layer is needed for the intended use of the mixed orientation substrate, the stiffening layer can play both roles, first of all the above mentioned cleavage prevention role during the splitting area forming process and secondly, it can provide the desired additional layer in one run. Depending on the desired thickness of the remaining layer, this thickness can be achieved using for instance CMP, plasma or HF etching after the ion implantation.

Preferably, the stiffening layer can be at least one of silicon dioxide, aluminium nitride and silicon nitride (Si₃N₄). These layers are particularly advantageous as, first of all, they provide the desired stiffening effect and second, can also serve as an insulating layer in case a mixed orientation substrate of the type silicon on insulator (SOI) or ultra thin buried oxide (UTBOX) is to be fabricated.

According to an advantageous embodiment, the stiffening layer can comprise a first layer and a second layer. As already described above, the stiffening layer can satisfy two requirements. First of all, the reduction of the negative impact of stress created during the splitting area formation, in this case the stiffening layer needs to have a certain minimum thickness, and second, a part of the stiffening layer can serve as a sandwiched layer in the mixed orientation substrate. The sandwiched layer in this embodiment is then materialized by one of the two layers. By providing two layers the method can be better adapted to the requirements.

Preferably, prior to Step e) the second layer, in particular only the second layer, is removed. Thus prior to attachment, the second layer, which is the layer only being necessary for stress reduction reasons, is removed so that only the layers which are necessary for the final mixed orientation substrate are present when the donor substrate is bonded to the handle substrate. In this way, the method is further optimized.

Preferably, the first layer can be a thermal oxide, in particular silicon dioxide, and/or the second layer a deposited layer, in particular an oxide or nitride, more in particular a deposited silicon dioxide layer. The layer can be deposited by CVD, PCVD, LPCVD in the form of a TEOS oxide for example. During removal of the second layer advantage can be taken from the fact that between the thermal oxide and the deposited layer the chemical selectivity is different, typically of the order of 4, so that the removal is facilitated and at the same time a removal from the first layer can be prevented. It is, for example, possible to use a simple HF treatment (1%) to remove a deposited silicon dioxide layer, having a higher porosity that the thermal silicon dioxide.

Preferably, the first layer can have a thickness of at most 70 nm, in particular a thickness of about 10 nm to 50 nm and/or the second layer a thickness in a range of 100 nm to 2 micrometers. With the described method comprising two layers the thickness of the stiffening layer necessary for the stress prevention can rapidly be achieved without having to care about the quality of the remaining layer, which is ensured by the thermal growth process of the first layer.

According to a further advantageous embodiment, the stiffening layer can be provided over the surface of the donor substrate which is opposite to the surface through which implantation will occur in Step b). Surprisingly, it was found that the stiffening layer does not only fulfil its role when it is provided on the surface through which ion implantation occurs, but also when it is applied to the backside of the donor substrate. This method has the advantage that when the donor substrate from which a layer has already been transferred is reused in a subsequent fabrication process, no new stiffening layer needs to be provided. This facilitates the fabrication method. In addition, no layer removal step is necessary in case a direct bonding between the donor substrate and the handle substrate is intended or in case only a thin layer not sufficient for stress reduction is sandwiched between the transferred layer and the handle substrate.

Preferably an insulating layer can be provided over the surface through which ion implantation occurred in Step c) or through which ion implantation occurs in Step c). Thus also in this embodiment it is possible to provide a mixed orientation substrate with an intervening layer which can either be provided before ion implantation or after ion implantation. In case the insulating layer is provided before ion implantation, this layer can, in addition, prevent contamination of the transferred layer during the ion implantation, but also facilitate the bonding step.

Preferably, the donor substrate can be a silicon (Si) wafer, in particular a silicon (110) wafer, or a gallium nitride (GaN) wafer or a germanium (Ge) wafer and/or the handle substrate can be silicon (100) wafer. Like already mentioned in the introduction, the stress created during ion implantation is larger in the (110) silicon than in the (100) silicon. Thus, by providing the stiffening layer it is still possible to reduce the problems due to cleavage and scratches.

According to a second inventive aspect, Step b) can comprise providing the donor substrate on an implantation wheel of a device for ion implanting, maintaining the donor substrate on the implantation wheel by maintaining means, wherein the twist angle of the donor substrate is chosen as a function of the position of the extremities of the maintaining means to thereby prevent cleavage occurring along the most fragile cleavage propagation directions during ion implantation.

The implanting of ions takes place in an implanting device in which a number of substrates is subjected to a linear ion beam. To implant over the entire surface the substrates are mounted on a rotating and/or translating implantation wheel so that the entire surface of the substrate passes under the ion beam. Maintaining means, like clips, are used to fix the substrate on the implanting wheel against the rotational forces. Usually the maintaining means are fixed restraints. Moreover, to drain electrical charges generated during implantation, metallic fixed restraint are used.

Surprisingly, it was found out that by rotating the (110) silicon substrate, i.e. by changing the twist angle, positions can be found for which the problem of breakage defectivity can be reduced or even eliminated. It is supposed that different wafer rotation positions with respect to the maintaining means are not equivalent in term of stress release during implantation. Thus, also with this stress preventing measure, substrates which might be too fragile to be used in the normal way, can be implanted.

According to an advantageous embodiment, at least two different species, in particular Hydrogen and a rare gas atom, in particular Helium, can be implanted during Step c). Co-implantation has the advantageous effect that blisters, non-transferred layers and scratches are reduced compared to the process where only one atomic species is implanted.

Preferably the Hydrogen can be implanted prior to the rare gas. In this case even better results concerning the crystalline qualities of the transferred layer have been observed.

The invention also relates to a donor substrate according to claim 17 and the use of a stiffening layer provided on one main surface of a donor substrate according to claim 18. As already mentioned above, a donor substrate provided with a stiffening layer prior to the implanting step to create the predetermined splitting area is superior to the donor substrate known in the prior art, as the cleavage problem leading to crystalline defects, like cleavage or scratches, in the mixed orientation substrate, in particular in the transferred layer of that substrate, do not occur.

Specific embodiments of the present invention will become more apparent from the present description with reference to the accompanying drawings wherein:
Figure 1 illustrates a first embodiment of the inventive method according to a first inventive aspect for fabricating mixed orientation substrates,
Figure 2 illustrates a second embodiment, being a variant of the first embodiment of the inventive method for fabricating mixed orientation substrates,
Figure 3 illustrates a third embodiment of the inventive method for fabricating mixed orientation substrates,
Figure 4 illustrates a fourth embodiment of the inventive method for fabricating mixed orientation substrates,
Figure 5 illustrates a fifth embodiment, being a variant of the fourth embodiment, and
Figures 6a to 6d illustrate a sixth embodiment, according to the second aspect of the invention.

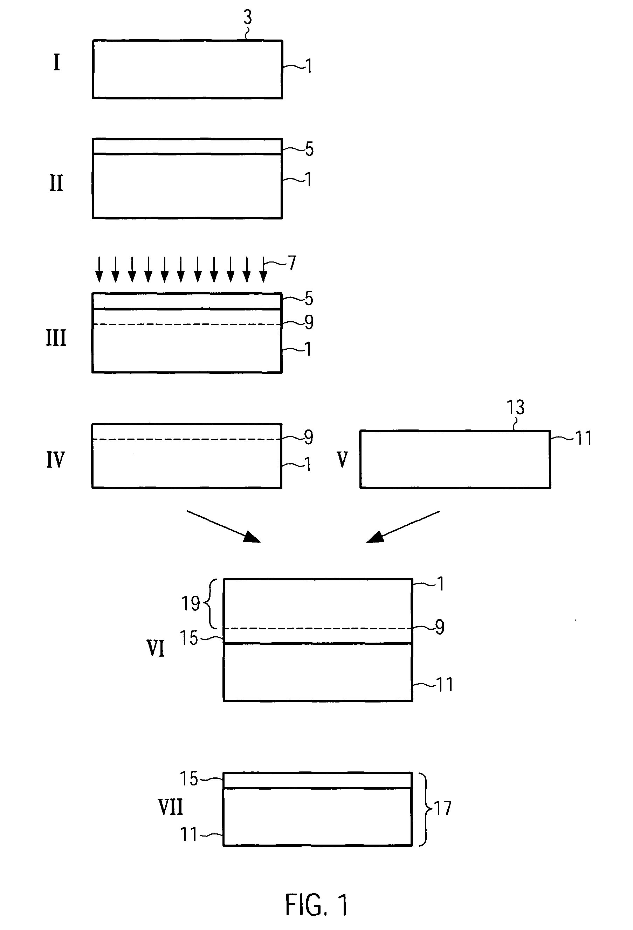

Figure 1 illustrates the first embodiment of the inventive method of fabricating a mixed orientation substrate. The method will be described for a silicon mixed orientation substrate. This material choice, however, only represents one possible realization, the inventive method is also applicable to other materials.

A mixed orientation substrate is characterized by the fact that the crystalline orientation of the one part of the substrate is different to the crystalline orientation in another part of the substrate, so that it becomes possible to take advantage of the crystal orientation dependent mobility of electrons and holes.

Step I of the inventive method consists in providing a donor substrate 1, in this embodiment a silicon wafer with a surface 3 having a (110) orientation according to Step a) of claim 1. The invention could, however, also be applied to other substrates, in particular substrates like GaN which have a tendency to break.

Step II then illustrates the step of forming a stiffening layer 5 on the donor substrate 1 according to Step b) of claim 1. In this embodiment the stiffening layer 5 is a silicon dioxide layer, however, other materials could also be used, like for example aluminium nitride. The stiffening layer 5 can be thermally grown under oxidizing conditions or deposited, for example by CVD, PCVD or LPCVD. The layer 5 is grown to a thickness of at least 50 nm, in particular 50 nm to 200 nm, preferably about 150 nm.

According to the invention, the stiffening layer 5 serves to counterbalance stress which may arise in the donor substrate in the following process step, namely during ion implantation. In fact the stress occurring during implantation leads to a bowing effect on the donor substrate 1 which in the state of the art process not providing the stiffening layer, leads to difficulties in the subsequent steps of bonding, which will be described further down.

Step III corresponds to Step c) of claim 1. During that step, atomic species 7 are implanted through the stiffening layer 5 to create a predetermined splitting area 9 inside the donor substrate 1. The predetermined splitting area 9 is essentially parallel to surface 3 of the donor substrate 1. The energy of the implanted atomic species is chosen such that the desired depth of the predetermined splitting area 9 inside the donor substrate 1 can be achieved.

Typically, Hydrogen or rare gas atoms are used as atomic species 7. According to a variant, the implantation step comprises implanting at least two different atomic species. In this case, preferably Hydrogen and Helium ions are used. It has been found that by first implanting Hydrogen and then the rare gas ions, thus for example Helium ions, the quality of the final product was superior with respect to the crystallinity of the transferred layer than in case only one species was used during implantation.

After Step III the stiffening layer 5 is, in this embodiment, removed from the donor substrate by using CMP, HF or plasma etching or any other suitable method. The result of this step is illustrated in Step IV.

Step V consists in providing a handle substrate 11, according to Step d) of claim 1, which has a different crystalline orientation of its surface 13 than the donor substrate 1. In this embodiment a silicon wafer with a (100) surface is used as the handle substrate 11.

The donor substrate 1 and/or the handle substrate 11 can then undergo surface preparation steps like cleaning (RCA), rinsing, plasma activation, brushing or drying.

According to a further variant, the donor substrate 1 and/or the handle substrate 11 are heat treated at a temperature between 900°C and 1200°C in an atmosphere comprising Hydrogen and/or Argon leading to hydrophobic surfaces.

Under subsequent Step VI, corresponding to Step e) of claim 1, the donor substrate 1 is bonded to the handle substrate 11. Bonding occurs such that the predetermined splitting area 9 lies towards the interface between the handle substrate 11 and the donor substrate 1.

Eventually the bonding step is accompanied by a thermal treatment to consolidate the interface. Such a treatment is carried out at a temperature between 200°C and 1200°C, preferably around 1100°C and is carried out for at least one hour, preferably for three hours. By this consolidation step, the bonding between the substrates is improved.

Then, the detachment treatment is carried out, during which detachment occurs at the predetermined splitting area 9, such that a layer 15 of the donor substrate 1 is transferred onto the handle substrate 11. The detachment treatment is typically a heat treatment. Alternatively, mechanical forces or a chemical treatment may also lead to the detachment of the transferred layer 15. Eventually also a combination of thermal, mechanical or chemical treatment may be applied.

The result of the detachment step is illustrated in Step VII showing a mixed orientation substrate 17 comprising the handle substrate 11 with a (100) surface orientation and the transferred layer 15 with a (110) surface orientation.

The remainder 19 of the donor substrate 1 (see Step VI in Figure 1) can then be reused as a new donor substrate 1 in Step I during a subsequent mixed orientation substrate fabricating process.

The mixed orientation substrate 17 may then undergo further treatment steps, like a final annealing or a polishing step, to obtain the final structure in particular with a polished surface.

With the inventive method according to the first embodiment, a mixed orientation substrate of the type silicon (110) on silicon (100) can be achieved. This type of substrate is also called a direct silicon bonding (DSB) substrate.

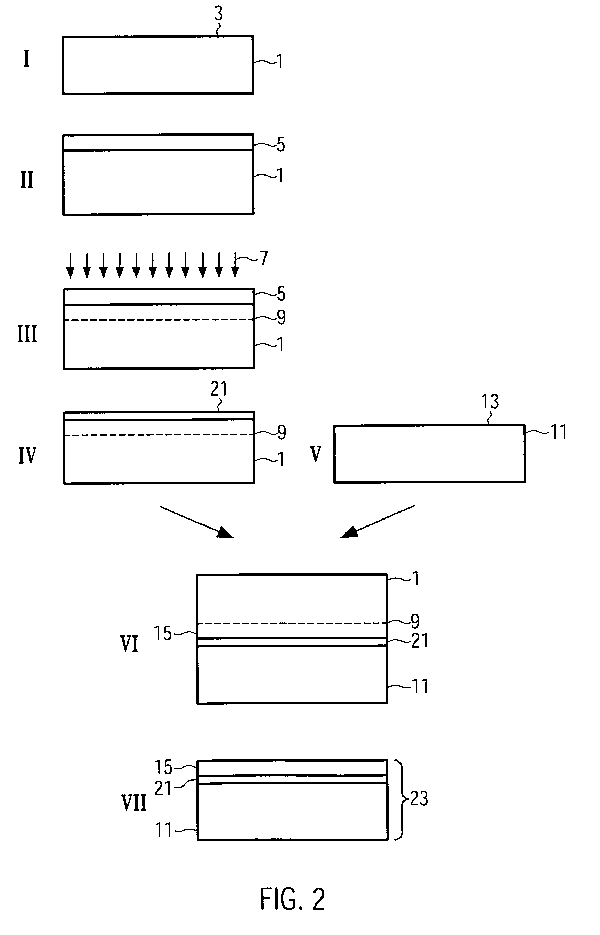

Figure 2 illustrates a second embodiment of the method for fabricating a mixed orientation substrate according to the invention and represents a variant of the first embodiment. The only difference between the two embodiments is that not the entire stiffening layer 5 is removed after the ion implantation Step III, but that a thinned layer remains. The other process Steps I to III and V correspond to Steps I to III and V of the first embodiment. Their description is therefore not repeated again in detail but is incorporated herewith by reference. In addition, the same reference numerals as in the first embodiment are reused in the second embodiment.

As a consequence, Step IV illustrates the result of the thinning process, namely a structure which comprises the donor substrate 1 with the predetermined splitting area 9 and a thinned stiffening layer 21 which has a thickness below 50 nm, in particular 25 nm.

Bonding of the donor substrate 1 to the handle substrate 11 occurs such that the thinned stiffening layer 21 is sandwiched between the donor substrate 1 and the handle substrate 11. This result is illustrated in Step VI of Figure 2. After detachment, a mixed orientation substrate 23 is obtained which comprises the transferred layer 15, the thinned stiffening layer 21 and the handle substrate 11 which is illustrated in Step VII of Figure 2.

With the inventive method according to the second embodiment, a mixed orientation substrate of the type silicon (110) on silicon (100) with a thinned stiffening layer sandwiched in between can be achieved. Thus in case the stiffening layer 5 is a silicon dioxide layer, a so called ultra thin buried oxide type substrate (UTBOX) is achieved.

Of course the variants and alternatives described in the first embodiment can also be applied in this second embodiment.

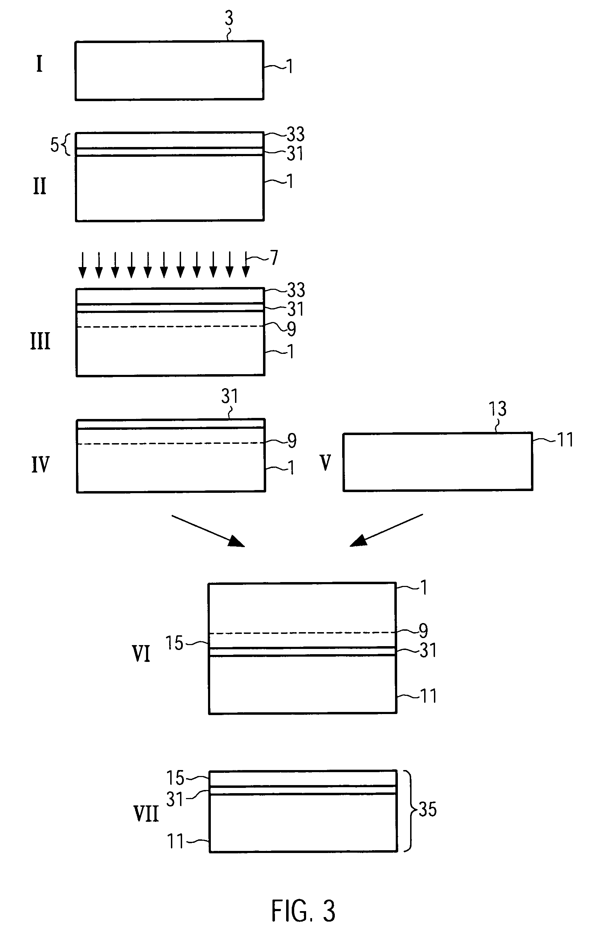

Figure 3 illustrates a third embodiment of the method for fabricating a mixed orientation substrate according to the invention. The difference with respect to the first and the second embodiment is that, instead of providing a single layer as stiffening layer 5, the stiffening layer 5 in this embodiment comprises at least two layers. The steps illustrated in Steps I, III and V correspond to Steps I, III and V of the first or second embodiment. Their description is therefore not repeated again in detail, but is incorporated herewith by reference.

As already mentioned, the difference of this embodiment compared to the first and second embodiments is that the stiffening layer 5 comprises two layers. First of all, a silicon dioxide layer 31 is grown directly on the donor substrate 1 using a thermal treatment. This first layer 31 is grown to a thickness of, at most, 70 nm, preferably to a thickness between 10 nm and 50 nm. Subsequently, a second layer 33 is deposited on the thermal oxide 31. Its thickness can vary from several hundreds of nm to several microns and is, for instance, deposited by CVD, PCVD or LPCVD. The material can either be a silicon dioxide, layer like TEOS oxide or silicon nitride.

In the subsequent Step III, the atomic species 7 are then implanted through the stiffening layer 5 being composed out of the two layers 31 and 33, to form the predetermined splitting area 9 inside the stiffening layer just like in the previous embodiments.

After implantation, the second layer 33 of the stiffening layer 5 is removed. To do so one takes advantage of the difference in chemical selectivity between the thick layer 33 and the thermal oxide 31. For silicon dioxide, the difference in chemical selectivity is of the order of four. Thus, the second layer 33 can be removed at high speed. This is essentially due to the fact that a deposited layer is less dense than a thermally grown layer. A HF attack (HF 1%) is typically applied to remove layer 33. The result of this step is shown in Step IV illustrating the donor substrate 1 with its predetermined splitting area 9 and the remaining first layer 31, thus the insulating silicon dioxide thermally grown.

This structure is then bonded to the handle substrate 11 illustrated in Step VI so that a bonded structure out of the handle substrate 11, the insulating layer 31 remaining from the stiffening layer 5 and the donor substrate 1 is achieved.

After detachment, which is carried out under the same conditions as previously described, a silicon on insulator substrate 35 is achieved comprising the transferred layer 15, the insulating layer 31 and the handle substrate 11. The silicon on insulator substrate 35 is also a mixed orientation substrate of the type UTBOX as the transferred layer 15 has a (110) surface and the handle substrate 11 a (100) surface, like in the other embodiments.

Of course, the variants and alternatives described in the first embodiment can also be applied in this second embodiment.

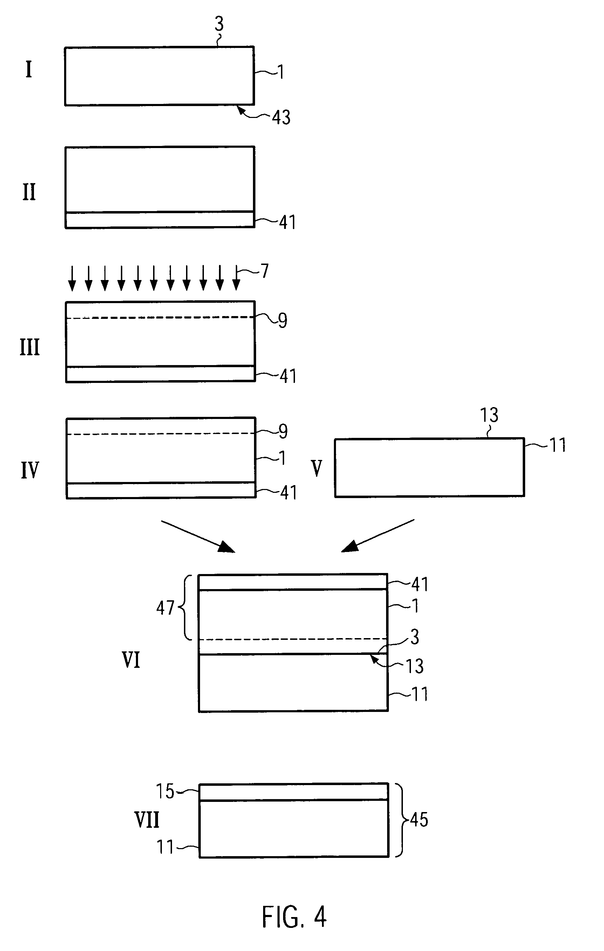

Figure 4 illustrates a fourth embodiment of the method for fabricating a mixed orientation substrate according to the invention. Compared to the first embodiments, the difference of this embodiment is that the stiffening layer is not provided on the main surface of the donor substrate through which implantation will occur but on the opposite main surface of the donor substrate. Steps I and V correspond to Steps I and V of the previous embodiments and will therefore not be repeated again in detail. Their description is incorporated herewith by reference. Again the same reference numerals will be used.

Step II illustrates the result of a stiffening layer forming process which provides a stiffening layer 41 on the back side of the donor substrate 1, wherein the backside is defined as being the surface 43 of the handle substrate 1 which is opposite surface 3 of the donor substrate 1 through which in the subsequent implantation step, the atomic species 7 are implanted to create the predetermined splitting area 9.

The stiffening layer 41 is a silicon dioxide or a silicon nitride layer, typically formed by deposition, but also a thermal treatment is suited to create the layer, and is formed with a thickness going from 100 nm to 1000 nm or even up to several micrometers. The thickness of the stiffening layer 41 is chosen as a function of the implantation dose which leads to the stress inside the donor substrate.

Step III, like in the previous embodiments, then illustrates the ion implantation step which is essentially the same as in the previous embodiments, their description is incorporated herewith by reference. The difference is just that the ions are not implanted through the stiffening layer 41, but directly through the surface of the donor substrate 1.

Step IV then illustrates the result obtained after ion implantation, namely the donor substrate 1 with the predetermined splitting area 9 and the stiffening layer 41 on the other surface 43 of the donor substrate 1, thus the side of the donor substrate which is further away from the predetermined splitting area 9 compared to the other main surface.

Like in the previous embodiments, the donor substrate 1 is then bonded to the handle substrate 11 (see Step V). Bonding occurs at the surfaces 13 and 3 of the handle substrate 11 and the donor substrate 1, respectively. After detachment at the predetermined splitting area - the detachment process is carried out like in the previous embodiments, and its description is incorporate herewith by reference - a direct silicon bonding substrate 45 like in the first embodiment, thus being composed out of the transferred layer 15 originating from the donor substrate 1 and the handle substrate 11 is achieved.

Like in the previous embodiments, the substrate 45 is a mixed orientation substrate.

In subsequent fabrication steps, the remainder of the donor substrate 47 is reused and as the stiffening layer 41 is already present, Step II does not need to be carried out again. Thus in this case, the fabrication process for subsequent mixed orientation substrates is realized with fewer process steps.

Of course, the variants and alternatives described in the first embodiment can also be applied in this second embodiment.

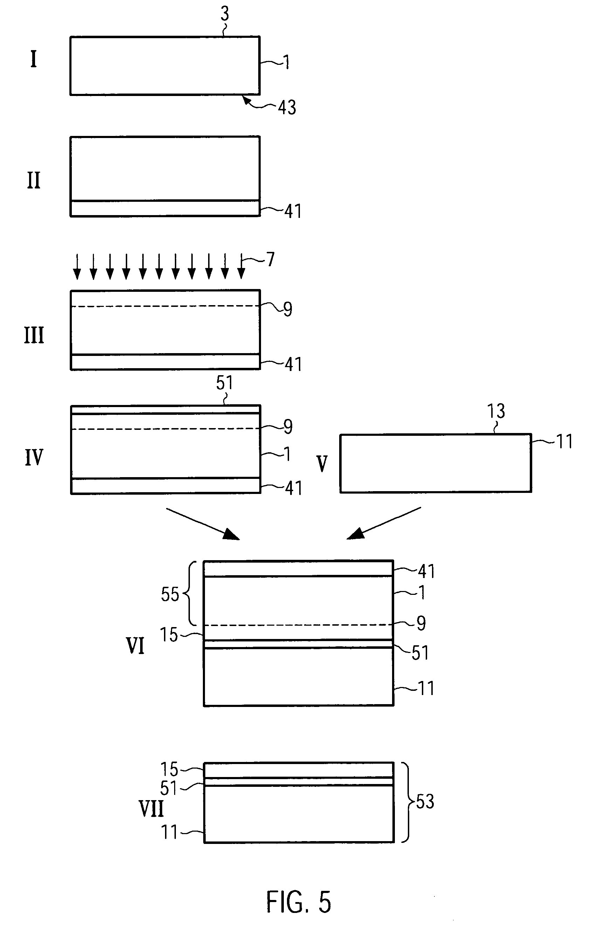

Figure 5 illustrates a fifth embodiment, being a variant of embodiment four of the method for fabricating a mixed orientation substrate according to the invention. The difference with respect to the fourth embodiment is that, after the implantation Step III an insulating layer 51 is provided on the surface 3 of the donor substrate 1 through which ion implantation occurred (see Step IV). The other Steps I to III and V correspond to the ones of the fourth embodiment and are therefore not repeated again in detail but are incorporated herewith by reference. The same reference numerals are used again.

Bonding between the handle substrate 11 and the donor substrate 1 together with its stiffening layer 41 and insulating layer 51 which is typically a thermally grown oxide, preferably silicon dioxide of a thickness from 5 nm to 50 nm, preferably 10 nm to 125 nm, is carried out such that the insulating layer 51 is sandwiched between the handle substrate 11 and the donor substrate 1 (see Step VI).

After the detachment treatment - corresponding to the one of the previous embodiments, the description of which is incorporated herewith by reference - a silicon on oxide substrate 53 of the type UTBOX is obtained, wherein the transferred layer 15 and the handle substrate 11 have a different crystalline orientation so that also in this case a mixed orientation substrate 53 is achieved. The remainder of the donor substrate 55 is then reused in subsequent fabrication process runs.

As an alternative, the insulting layer 51 could also be formed on the donor substrate prior to the ion implantation step. In this case the silicon layer 15 which will be transferred later on can be protected from any contamination during the implanting step.

Of course the variants and alternatives described in the first embodiment can also be applied in this second embodiment.

All embodiments one to five and their variants and alternatives have in common that, due to providing a stiffening layer 5 or 41 respectively, the bowing effect which occurs due to stresses arising during ion implantation can be suppressed or at least reduced so that a breakage or deformation of the transferred layer 15 on the handle substrate 11 can be prevented or at least reduced compared to the known process not using stiffening layers. It is important to mention that to achieve the stiffening effect, the stiffening layer needs to have a thickness which, compared to the stress induced by implantation, is sufficient to prevent the above-mentioned negative effects. With thicknesses of the stiffening layer exceeding 50 nm, in particular more than 100 nm, this is usually achieved. In particular, in the case of (110) silicon the presence of the stiffening layer plays an important role as in this crystalline direction [-110] the stress resulting from the ion implantation is the largest compared to the other crystalline directions like [001].

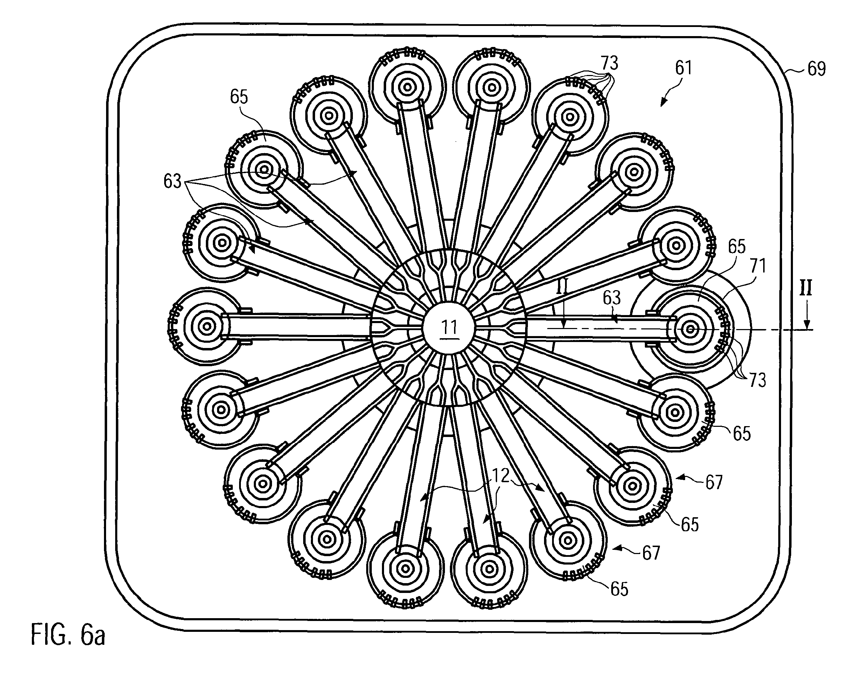

Figures 6a to 6d illustrate a sixth embodiment of the invention according to the second inventive aspect, namely the special alignment of the donor substrate in the ion implantation device used to create the predetermined splitting area. The sixth embodiment can be combined with any one the embodiments one to five or any of their variants.

A state of the art ion implantation device of the batch type is used to create the predetermined splitting area in the donor substrate. Applied Material Implanters can be used like for example the Quantum III. Such a device, illustrated in Figure 6a, comprises an implantation wheel 61 comprising a plurality of arms 63 each having at its outside extremities a support 65 on which the donor substrate 67 to be treated is positioned and which is furthermore configured to rotate about its centre. The implantation wheel 61 is positioned inside a chamber 69, which also comprises a stationary ion beam generator 71 configured to emit an ion beam. During ion implanting the implantation wheels 61 rotates and/or translates and thereby the entire surface of the donor substrates 67 is swept by the ion beam. Maintaining means 73, here fixed metallic restraints, which are present at each support 65 of the wheel 61, are configured to keep the donor substrates 67, which are the same kind of donor substrate like in the previous embodiments, on the wheel 61 when it is rotating. The arrangement of the maintaining means on the periphery of the support 65 can vary for different types of ion implanters.

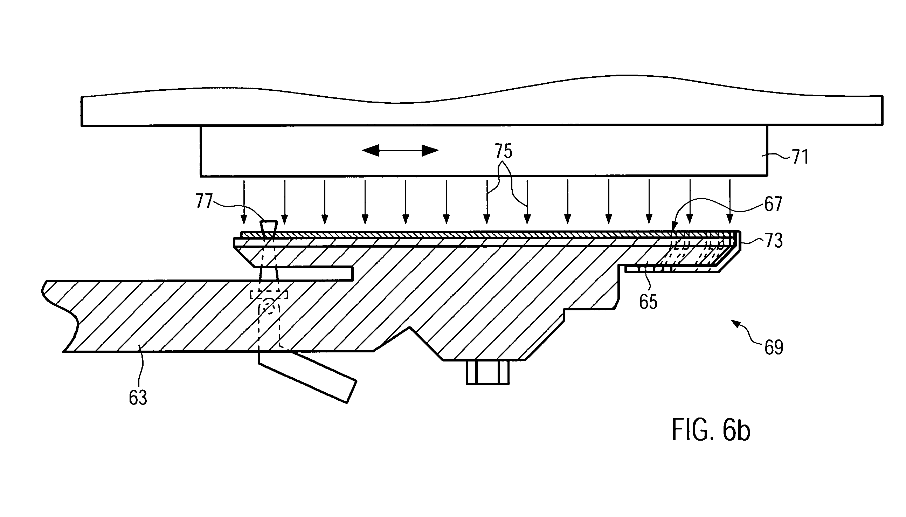

Figure 6b illustrates a side cut view along a radial direction of the implantation wheel 61 of the situation in Figure 6a (cut along II - II). The ion beam generator 71 is positioned inside the chamber 69 and in an upper part thereof. The support 65 is positioned underneath the beam generator 71 and comprises on its outside extremity the maintaining means 73. During implanting the ion beam generator 71 emits an ion beam 75 towards the donor substrate 67 which is therefore swept by the ion beam by the rotating and/or translating movement of the implantation wheel 61. On the side towards the centre of the wheel movable clips 77 are arranged which also serve to keep the donor substrate 67 on the support 65.

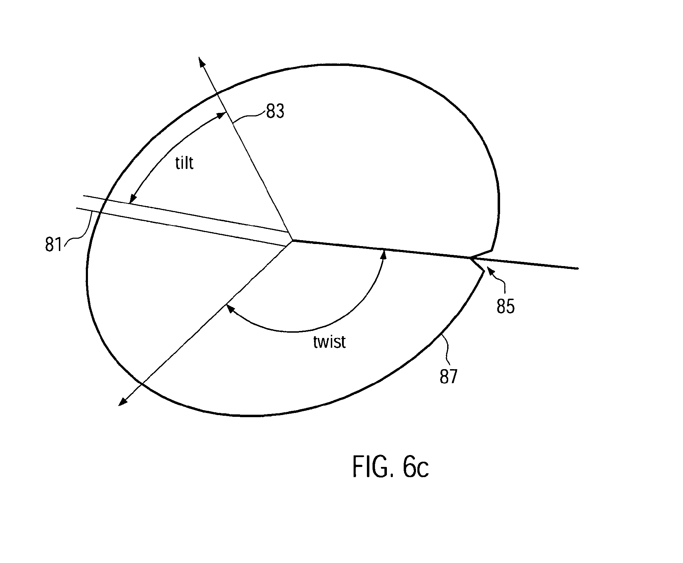

Figure 6c illustrates the definition of the two angles commonly used to define the direction of the ion beam 81: the twist and the tilt angle. The angle between the wafer surface normal 83 and the ion beam 81 is the tilt angle. The twist angle is necessary to completely describe the direction of incidence of the ion beam 81. It is the angle between the plane containing the ion beam 81 and the wafer normal 83, and the plane perpendicular to the primary flat or in the direction of the notch 85 (as shown in Fig. 6e of the wafer 87 containing the wafer normal.

Usually, the notch 85 of the wafer is always placed at the bottom when it is placed on the support of the wheel corresponding to a twist value of 0° (under the assumption that the tilt angle has a value different to 0° and that the inclination of the ion beam is in a plane normal to the plane of figure 6b. It has been found that breakage of a Si (110) substrate starts at one of the extremities of the maintaining means 73 and consists of an opening of the {111} planes, in case the extremity of the maintaining means coincides with the most fragile cleavage propagation direction. This (111) cleavage has three equivalent axes of stable cleavage propagation: the [2-1-1], [-12-1],[-1-12] axes.

In the case of a Silicon (110) donor wafer and if the wafer twist angle is held at 0° into the implanter, two cleavage propagation directions have been observed, depending of the starting point of the breakage during H+ and He+ implantation. When the breakage starts at the upper fixed restraint extremity, the propagation direction of the cleavage is <-11-2>. When the breakage start at lower fixed restraint extremity, the cleavage propagation follows the <-112> direction.

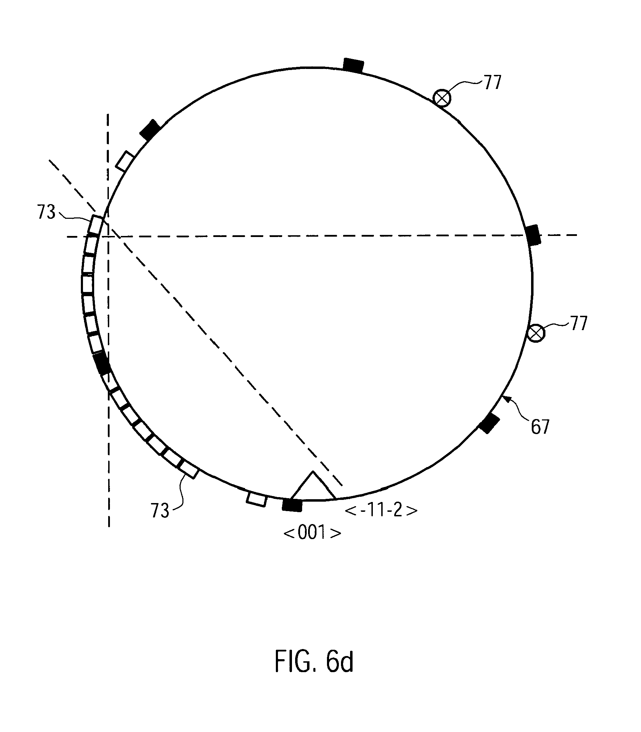

Figure 6d illustrates a corresponding top view onto a real donor substrate 67 being a Si (110) wafer. The cleavage starts at the upper extremity of the fixed restraint and propagates along <-11-2>. In this figure the same reference numerals as in Figures 6a and 6b are reused. As can be seen the donor substrate 67 is held by not only one maintaining means 73, but by a plurality of maintaining means. The arrangement of the maintaining means 73 on the periphery of the support corresponds to the actual positions in the used ion implanters. The arrangement in Figure 6a is slightly different, as it corresponds to a conceptual drawing only. The view of figure 6d corresponds to a view onto the wafer when introduced on the implantation wheel 61 and looking from the ion beam generator 71 towards the support. Therefore the maintaining means 73 are on the left hand side of figure 6d.

According to the invention, the cleavage problem can be prevented by choosing a different twist angle compared to the ones for which cleavage occurs. In the implanting tool mentioned above, the Si (110) donor substrate 61 is aligned on the support 67 such that the twist angle, is in a range of 17° to 25° or 305° to 317° to reduce the cleavage defectivity, and preferably 22° or 312° to eliminate the cleavage defectivity. Here the twist angle is defined in a clockwise manner. Optimizing the twist angle has thus the advantage that the stress influence on the (110) Silicon wafer due to the fixed restraint extremities is reduced and can even be completely removed. It has therefore been found that by aligning in this way less or no breakage of the donor substrate was observed and this even in the more critical material Si (110).

## Claims

1. Method for fabricating a mixed orientation substrate comprising the steps of:
a) providing a donor substrate (1) with a first crystalline orientation,
b) subjecting the donor substrate (1) to a stress preventing measure,
c) forming a predetermined splitting area (9), in particular by ion implantation, in the donor substrate (1),
d) providing a handle substrate (11), in particular of a second crystalline orientation being different from the first crystalline orientation,
e) attaching, in particular by bonding, the donor substrate (1) to the handle substrate (11), and
f) detaching the donor substrate (1) at the predetermined splitting area (9), thereby transferring a layer of the donor substrate (1) onto the handle substrate (11) to from a mixed orientation substrate.

2. Method according to claim 1, wherein step b) comprises providing a stiffening layer (5) over the surface of the donor substrate (1).

3. Method according to claim 2, wherein the stiffening layer (5) has thickness of at least 50nm, in particular 50 to 200nm, even more in particular about 150nm.

4. Method according to claim 2 or 3, wherein the stiffening layer (5) is at least partially removed prior to Step e).

5. Method according to claim 4, wherein after thinning, the stiffening layer (5) has a thickness of at most 50nm, in particular 25nm.

6. Method according to one of claims 2 to 5, wherein the stiffening layer (5) is at least one of Si02, AIN and Si₃N₄.

7. Method according to one of claims 2 to 6, wherein the stiffening layer (5) comprises a first layer (31) and a second layer (33).

8. Method according to claim 7, wherein prior to Step e) the second layer (33), in particular only the second layer (33), is removed.

9. Method according to claim 7 or 8, wherein the first layer (31) is a thermal oxide, in particular Si02, and/or the second layer (33) a deposited layer, in particular an oxide or nitride layer, more in particular a deposited Si02 layer.

10. Method according to one of claims 7 to 9, wherein the first layer (31) has a thickness of at most 70nm, in particular a thickness of about 10 to 50 nm, and/or the second layer (33) has a thickness in a range of 100nm to 2µm.

11. Method according to one of claims 2 to 10, wherein the stiffening layer (41) is provided over the surface of the donor substrate (1) which is opposite to the surface (3) through which ion implantation will occur in Step c).

12. Method according to claim 11, wherein an insulating layer (51) is provided over the surface (3) through which ion implantation will occur in Step c) or has occurred in Step c).

13. Method according to one of claims 1 to 12, wherein the donor substrate (1) is a silicon (Si) wafer, in particular a Si (110) wafer, a gallium nitride (GaN) wafer or a germanium (Ge) wafer, and/or the handle substrate (11) is a Si wafer, in particular a Si (100) wafer.

14. Method according to one of steps 1 to 13, wherein step b) comprises providing the donor substrate (1) on an implantation wheel (61) of a device for ion implanting, maintaining the donor substrate (67) on the implantation wheel (61) by maintaining means (73), wherein the twist angle of the donor substrate (67) is chosen as a function of position of the extremities of the maintaining means (73) to thereby prevent cleavage occurring along the most fragile cleavage propagation directions during ion implantation..

15. Method according to one of claims 1 to 14, wherein at least two different species, in particular hydrogen and a rare gas atom, in particular He, are implanted during Step c).

16. Method according to claim 15, wherein hydrogen is implanted prior to the rare gas atoms.

17. Donor substrate for fabricating a mixed orientation substrate, comprising a predetermined splitting area (9) close to one main surface (3) and a stiffening layer (41) over the other main surface.

18. Use of a stiffening layer provided on one main surface of a donor substrate (1) used in the process of fabricating a mixed orientation substrate according to one of claims 1 to 16.
